# EUROPEAN PATENT APPLICATION

(11) **EP 4 844 433 A1**
(43) Date of publication of application: **25.11.2026**
(21) Application number: 25178131.6
(22) Date of filing: 22.05.2025
(51) Int. Cl.: G01R 35/00

(54) **CALIBRATION MODULE, MULTI-PORT CALIBRATION SYSTEM, AND CALIBRATION METHOD**

(71) Applicant: Rohde & Schwarz GmbH & Co. KG, 81671 München (DE)
(72) Inventor: Pippers, Simon, 81671 München (DE)
(74) Representative: Prinz & Partner mbB

(57) **Abstract**

A calibration module (22) for a multi-port calibration system (12) is described. The calibration module (22) comprises at least one communication port (28), wherein the at least one communication port (28) is connectable to at least one further calibration module (22). The calibration module (22) is configured to transmit a calibration information signal to the at least one further calibration module (22) via the at least one communication port (28), wherein the calibration information signal comprises information on the RF signal received. The calibration module (22) is configured to receive at least one further calibration information reception signal from the at least one further calibration module (22) via the at least one communication port (28), wherein the calibration information signal comprises information on at least one further RF signal received by the at least one further calibration module (22). Further, a multi-port calibration system (12) and a calibration method are described.

## Description

The present invention generally relates to a calibration module for a multi-port calibration system. The present invention further relates to a multi-port calibration system and to a calibration method of calibrating a test and/or measurement system.

In the realm of radio frequency (RF) testing and RF measurements, accurate calibration is paramount to ensure the fidelity of measurement results.

As RF technology continues to evolve, the need for precision in calibration becomes increasingly critical, especially in multi-port systems where signal pathways are complex and intertwined.

Multi-port test and/or measurement system have emerged as sophisticated solutions for testing and/or performing measurements on a device under test or system under test.

However, with increasing number of ports and thus with increasing number of signal paths to be considered, the effort necessary for calibrating the test and/or measurement system increases dramatically.

Thus, the object of the present invention is to provide a calibration module, system, and method that facilitate calibration of complex multi-port systems.

According to the present invention, the problem is solved by a calibration module for a multi-port calibration system. The calibration module comprises at least one base port, wherein the at least one base port is connectable to a base module, and wherein the at least one base port is configured to receive a radio frequency (RF) signal. The calibration module comprises at least one test port, wherein the at least one test port is connectable to a device under test, wherein the calibration module is configured to output, via the at least one test port, a test signal corresponding to the RF signal. The calibration module comprises at least one communication port, wherein the at least one communication port is connectable to at least one further calibration module. The calibration module is configured to transmit a calibration information signal to the at least one further calibration module via the at least one communication port, wherein the calibration information transmission signal comprises information on the RF signal received. The calibration module is configured to receive at least one further calibration information signal from the at least one further calibration module via the at least one communication port, wherein the at least one further calibration information signal comprises information on at least one further RF signal received by the at least one further calibration module.

Therein and hereinafter, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Hereinafter, the term "calibration plane" is understood to denote a plane of the multi-port calibration system up to which the transmission properties of the multi-port calibration system are known, which allows to correct the at least one RF signal such that the at least one test signal has desired properties at the calibration plane. The known transmission properties may comprise a frequency response, an impulse response, a step response, a delay, a gain, and/or a phase response between a signal source generating the RF signal and the calibration plane. Moreover, the known transmission properties may comprise a frequency response, an impulse response, a step response, a delay, a gain, and/or a phase response between the signal source generating the RF signal and the calibration plane relative to the at least one further calibration plane.

The term "a test signal corresponding to the RF signal" is understood to denote that the test signal may be the RF signal or a processed version thereof. Accordingly, the calibration module may comprise signal-conditioning components such as amplifiers, attenuators, delay units, etc., which may process the RF signal, thereby obtaining the test signal.

Moreover, the term "device under test" is understood to denote both individual devices as well as systems under test comprising several individual devices and/or components.

The calibration module according to the present invention is based on the idea to enable inter-module communication for the calibration module by providing dedicated inter-module communication channels enabling exchange of the calibration information signals.

This enables a precise calibration up to predetermined calibration planes, as the information on the RF signals can be exchanged between the calibration modules, which enables to precisely adapt the individual RF signals and thus the individual test signals according to requirements of a measurement to be performed.

In fact, the different calibration modules or rather the test signals at the calibration planes can be equilibrated by exchanging the information on the RF signals, such that the properties of the test signals at the different calibration planes are known relative to each other, e.g. relative amplitudes, relative phases and/or relative delays of the test signals.

Figuratively, the individual calibration planes of the different calibration modules can be merged into a single calibration plane based on the information on the RF signals exchanged between the calibration modules.

Therein, an influence of the calibration modules on the RF signals is known, such that the properties of the test signals at the predetermined calibration planes can be deduced from the corresponding properties of the RF signals.

For example, the calibration plane may be located at the at least one test port.

No user interaction may be required for the calibration, as the calibration may be performed automatically based on the calibration information signals exchanged.

With the calibration module according to the present invention, the calibration can be performed without the device under test being connected, i.e. no signal has to be sent to the device under test during the calibration. Thus, the device under test is protected during the calibration procedure.

Alternatively, the device under test may be connected to the calibration module during the calibration, but the calibration module may block the test signal from being output, for example by disconnecting the test port from the base port.

After the calibration, it is not necessary to disconnect the calibration module. As the calibration module is configured to provide the test signal to the device under test, the calibration module can remain in the signal chain when tests and/or measurements are performed on the device under test.

Thus, the calibration module according to the present invention greatly facilitates the calibration of multi-port test and/or measurement systems.

As the calibration plane is located at the output of the calibration module, i.e. at the test port, it is not necessary to know or determine the exact transmission properties of any other components upstream of the test port, such as RF cables and/or signal-conditioning modules. Thus, the overall effort necessary for the calibration is reduced.

In fact, the calibration module according to the present invention also facilitates scalability of the test and/or measurement system, as the calibration based on inter-module communication between the calibration modules can be performed for an arbitrary number of signal paths or rather signal channels by providing a corresponding number of calibration modules.

The calibration information signals may each be an analog signal or a digital signal.

According to an aspect of the present invention, the calibration information signals comprise characteristic signal parameters of the respective RF signal, particularly wherein the characteristic signal parameters comprise an amplitude of the RF signal, a signal level of the RF signal, a phase of the RF signal, a delay of the RF signal, and/or a signal to noise ratio of the RF signal. Accordingly, instead of transmitting the complete RF signals between the calibration modules, only the characteristic signal parameters may be transmitted, which reduces the necessary bandwidth. However, all relevant signal parameters can be accounted for during the calibration, which ensures a highly precise calibration.

It is to be understood that the characteristic signal parameters may comprise any other suitable signal parameters.

In fact, the calibration information signals may each either be equal to the respective RF signal or may only comprise the respective characteristic signal parameters.

In an exemplary embodiment of the present invention, the calibration module comprises a characterization module, wherein the characterization module is configured to process the RF signal received, thereby obtaining the characteristic signal parameters. Thus, the calibration module has an integrated processing capability that reduces reliance on external measurement devices and simplifies setting up calibration and measurements. By internally processing or rather analyzing the received RF signal, the calibration module can swiftly obtain the characteristic signal parameters described above.

According to another aspect of the present invention, the calibration module comprises an analysis module, wherein the analysis module is configured to obtain calibration data based on the RF signal received and based on the at least one further calibration information signal. Thus, the calibration can be performed by the calibration module(s) without extra external devices or manual measurements being necessary. This built-in calibration functionality allows for a quicker and more accurate multi-channel alignment and calibration.

In a further exemplary embodiment of the present invention, the calibration module comprises at least one backward channel, wherein the calibration module is configured to transmit the calibration information signal and/or a measurement signal to the base module and/or to a central control device via the backward channel. In other words, a dedicated backward channel for transmitting calibration data and/or measurement signals is provided, which enables real-time data exchange between the calibration module and the base module and/or the central control device as well as a quick recalibration.

Therein, the same port and/or the same cable may be used for transmitting the RF signal from the base module to the calibration module and for transmitting the calibration information signal and/or the measurement signal to the base module, which further simplifies the calibration and/or measurement setup.

Alternatively, different ports and/or different cables may be used for transmitting the RF signal from the base module to the calibration module and for transmitting the calibration information signal and/or the measurement signal to the base module.

The measurement signal may be a signal transmitted by the device under test or a signal reflected at the device under test. In fact, the measurement signal may be a signal transmitted by the device under test in response to one of the test signals applied to the device under test, or the measurement signal may correspond to the test signal being reflected at the device under test.

It is noted that during testing of the device under test, there may be undesired reflections of the test signal at the device under test. These undesired reflections may be forwarded to the analysis module described above, and the analysis module may take these reflections into account for determining real-time calibration data. Based on the real-time calibration data, the RF signal may be adapted in order to compensate for the reflected portions of the test signal.

According to the present invention, the problem further is solved by a multi-port calibration system. The multi-port calibration system comprises at least one base module and at least two calibration modules, wherein the at least two calibration modules are each configured according to any one of the variants described above. The at least one base module comprises at least two RF ports, wherein the at least two RF ports are connected to the base ports of the at least two calibration modules. The communication ports of the at least two calibration modules are connected with each other.

The multi-port calibration system according to the present invention enables effortless scaling to a large number of RF channels and provides a consistent calibration plane for each signal path, even when multiple base modules or different topologies (e.g. daisy chain or star) are used.

Regarding the further advantages and properties of the multi-port calibration system, reference is made to the explanations given above with respect to the calibration module, which also hold for the multi-port calibration system and vice versa.

According to an aspect of the present invention, the multi-port calibration system, particularly the at least one base module and/or at least one of the at least two calibration modules, comprises a control module, wherein the control module is configured to generate a control signal for adapting the RF signal and/or the at least one further RF signal. In fact, the control module may be configured to generate the control signal based on the calibration data obtained by the analysis module described above. Thus, the multi-port calibration system may be calibrated automatically with minimal or even no user intervention being required.

The multi-port calibration system may comprise at least one signal-conditioning module for each signal path between the RF ports and the test ports. This allows precise, localized control of signal parameters, thereby enabling a precise and fast calibration.

In fact, the at least one signal-conditioning module may be integrated into the respective calibration module being connected to the respective signal path.

Alternatively, the at least one signal-conditioning module may be provided separately from the calibration module.

In an exemplary embodiment of the present invention, the at least one signal-conditioning module comprises an amplifier, an attenuator, a filter, a delay unit, and/or a frequency translator. This allows precise, localized control of the amplitude of the test signal, of a delay of the test signal, of a bandwidth of the test signal and a frequency content of the test signal, as well as of a center frequency of the test signal.

In a further exemplary embodiment of the present invention, the at least one base module is a signal generator, a vector network analyzer, an oscilloscope, or a spectrum analyzer. However, it is to be understood that the at least one base module may be any other suitable type of test and/or measurement device, or may be integrated into any suitable type of test and/or measurement device.

According to an aspect of the present invention, the at least two calibration modules are connected with each other via a daisy chain and/or via a connection having a star topology. This allows to interconnect the calibration modules in a defined manner, which reduces the complexity of setting up the multi-port calibration system significantly.

In fact, the daisy chain and star topologies make it particularly easy to scale the multi-port calibration system to a higher number of channels, i.e. to a higher number of ports, which corresponds to a higher number of calibration modules to be connected to each other.

However, it is to be understood that any other suitable type of connection topology may be used.

According to another aspect of the present invention, the at least two calibration modules are connected to each other directly or via the at least one base module.

Therein, the calibration modules being connected to each other "directly" is understood to denote that the calibration information signals are transmitted between the calibration modules via a dedicated connection that is provided separately from the base module and that does not extend through the base module.

If the calibration modules are connected to each other via the at least one base module, the calibration information signals may be transmitted via a dedicated connection that extends through the base module at least partially.

In an exemplary embodiment of the present invention, one of the at least two calibration modules serves as reference module for calibration of the multi-port calibration system. In fact, the RF signal received by one of the calibration modules and thus the test signal at the predetermined calibration plane of one of the calibration modules may serve as reference signal for the calibration of the multi-port calibration system.

Accordingly, the RF signal received by the reference module may be compared with the RF signals received by each of the other calibration modules based on the calibration information signals exchanged by the calibration modules. This allows to adjust the signal parameters of the test signals, such as amplitude, phase, delay, etc., with respect to a common reference, namely the test signal at the calibration plane of the reference module.

However, it is to be understood that choosing a reference module for the calibration is optional.

Alternatively, the multi-port calibration system may be calibrated without choosing a reference module.

In this case, each calibration module may transmit the respective calibration information signal to each other calibration module, which allows for equilibrating the test signals at the different calibration planes without choosing a reference module.

An aspect of the present invention provides that each of the at least two calibration modules comprises a housing. Accordingly, each calibration module can be placed independently of the other calibration modules, as each calibration module comprises its own housing. This allows for an optimal placement of the individual calibration modules with respect to the corresponding ports of the device under test.

A further aspect of the present invention provides that the at least two calibration modules are arranged in a common housing. By integrating the at least two calibration modules in the common housing, a highly integrated measurement setup with minimal cabling requirements can be achieved.

It is noted that it is also possible that a certain number of calibration modules is integrated into a common housing, and that multiple such housings each comprising a plurality of calibration modules may be provided.

According to the present invention, the problem further is solved by a calibration method of calibrating a test and/or measurement system, wherein the calibration method comprises the steps of
- generating, by at least one base module, a plurality of RF signals;
- forwarding the plurality of RF signals to a plurality of calibration modules, wherein the calibration modules are configured according to any one of the variants described above;
- exchanging calibration information signals between the calibration modules, wherein the calibration information transmission signals comprise information on the RF signals;
- obtaining calibration data based on the calibration information signals; and
- calibrating the test and/or measurement system based on the calibration data.

The multi-port calibration system described above may be configured to perform the calibration method.

Regarding the further advantages and properties of the calibration method, reference is made to the explanations given above with respect to the calibration module and the multi-port calibration system, which also hold for the calibration method and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a test and/or measurement system with a multi-port calibration system according to the present invention;
- Figure 2 shows a portion of the multi-port calibration system of Figure 1 according to a further variant;
- Figure 3 shows a portion of the multi-port calibration system of Figure 1 according to a further variant;
- Figure 4 shows a further variant of signal paths in the multi-port calibration system of Figure 1;
- Figure 5 schematically shows a calibration module of the multi-port calibration system of Figure 1;
- Figure 6 schematically shows a further variant of the calibration module; and
- Figure 7 shows a flow chart of a calibration method according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

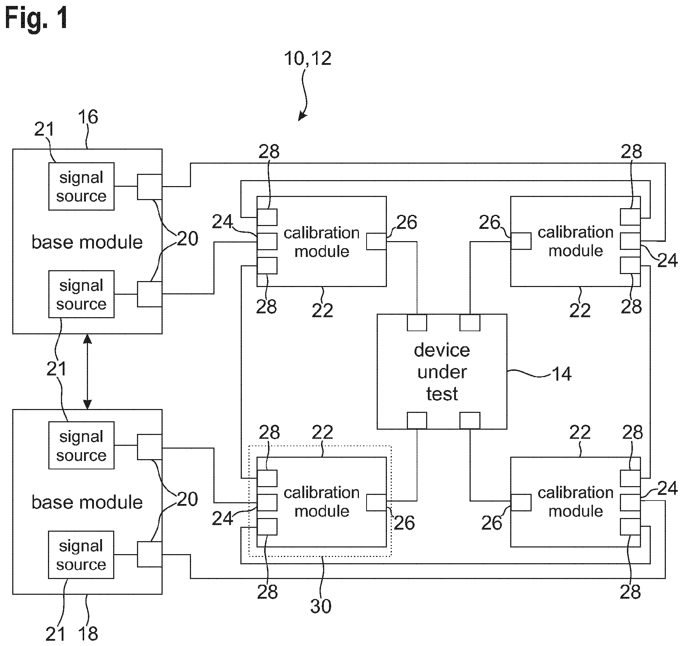

Figure 1 schematically shows a test and/or measurement system 10 comprising a multi-port calibration system 12 and a device under test 14.

In general, the test and/or measurement system 10 is configured to perform tests and/or measurements on the device under test 14, wherein the device under test 14 is an arbitrary multi-port electronic device or electronic multi-port system.

For example, the device under test 14 may be an electronic circuit, a radar system, particularly a vehicle radar system, an RF antenna array, a phased antenna array, a multiple-input-multiple-output (MIMO) array, a control circuit for a machine or vehicle, or any other type of electronic device or electronic system comprising a plurality of input ports and/or a plurality of output ports.

Therein, the multi-port calibration system 12 is configured to calibrate the test and/or measurement system 10 prior to performing measurements on the device under test 14.

In the exemplary embodiment shown in Figure 1, the multi-port calibration system 12 comprises a first base module 16 and a second base module 18, wherein the base modules 16, 18 each comprise two RF ports 20 and a signal source 21 for each RF port 20.

The signal sources 21 are connected to the RF ports 20, such that RF signals generated by the signal sources 21 can be output via the RF ports 20.

For example, the first base module 16 and the second base module 18 may both be established as a signal generator, for example as an arbitrary waveform generator.

As another example, the first base module 16 and the second base module 18 may each be established as a vector network analyzer, as an oscilloscope, or as a spectrum analyzer.

However, it is to be understood that the first base module 16 and the second base module 18 may be any other suitable type of device being configured to perform the functionality described below, particularly any other suitable type of test and/or measurement instrument.

Moreover, it is to be understood that only a single base module or more than two base modules each having an arbitrary number of RF ports may be provided, given that the total number of RF ports 20 is greater than or equal to 2.

The base modules 16, 18 may be connected with each other, for example in order to synchronize the base modules 16, 18 with each other.

The multi-port calibration system 12 further comprises a plurality of calibration modules 22, namely one calibration module 22 per RF port 20 to be connected to the device under test 14.

In the exemplary embodiment shown in Figure 1, the calibration modules 22 are provided separately from each other, wherein each calibration module 22 may be arranged in a separate housing.

Alternatively, two or more calibration modules 22 may be arranged in a common housing.

According to a further variant, two or more calibration modules 22 may be integrated into the first base module 16 and/or into the second base module 18.

The calibration modules 22 each comprise a base port 24, wherein the base port 24 is connected to one of the RF ports 20.

Therein, the base ports 24 of the calibration modules 22 may be connected to the RF ports 20 by suitable RF cables.

It is noted that the transmission properties of the RF cables do not have to be known, i.e. it is not necessary to know properties such as a frequency response, an amplitude response, and/or a phase response of the RF cables.

The calibration modules 22 further each comprise a test port 26, wherein the test port 26 is connected to the device under test 14, particularly to an input port or to an output port of the device under test 14.

Moreover, each calibration module 22 comprises at least one communication port 28.

In general, the calibration modules 22 are connected to each other via the communication ports 28, wherein the connection has an arbitrary suitable topology.

It is noted that transmission properties of the connections between the calibration modules 22 do not have to be known, as these connections can be characterized during the calibration described below.

Optionally, one of the calibration modules 22 is selected (manually or automatically) as reference module 30.

All other calibration modules 22 are connected to the reference module 30 via the at least one communication port 28, wherein the connection has an arbitrary suitable topology.

In fact, an arbitrary type of connection may be used for connecting the communication ports 28 to each other, as long as the connection allows for transmitting signals between the calibration modules 22 at least during a calibration of the test and/or measurement system 10, particularly for transmitting signals from the reference module 30 to the respective calibration module 22 and for transmitting signals from the respective calibration module 22 to the reference module 30.

In fact, the connections between the calibration modules 22 and the reference module 30 may be reciprocal at least during the calibration of the test and/or measurement system 10.

In general, the type of connection used for connecting the calibration modules 22 with each other is arbitrary.

For example, the connection may be cable-based, wireless, or optical.

As another example, the connections may comprise mixers and/or frequency dividers that are configured to adapt a respective frequency of the respective signal transmitted.

In the exemplary embodiment shown in Figure 1, the calibration modules 22 each comprise two communication ports 28, and the calibration modules 22 are connected to each other in a daisy chain.

It is emphasized that choosing one of the calibration modules 22 as reference module 30 is optional. Alternatively, the calibration modules 22 or more precisely the communication ports 28 of the calibration modules 22 can be connected to each other such that each calibration module 22 can exchange signals with each other calibration module 22. Therein, any suitable topology such as a daisy chain and/or a star connection may be used.

This likewise holds for the exemplary topologies described hereinafter.

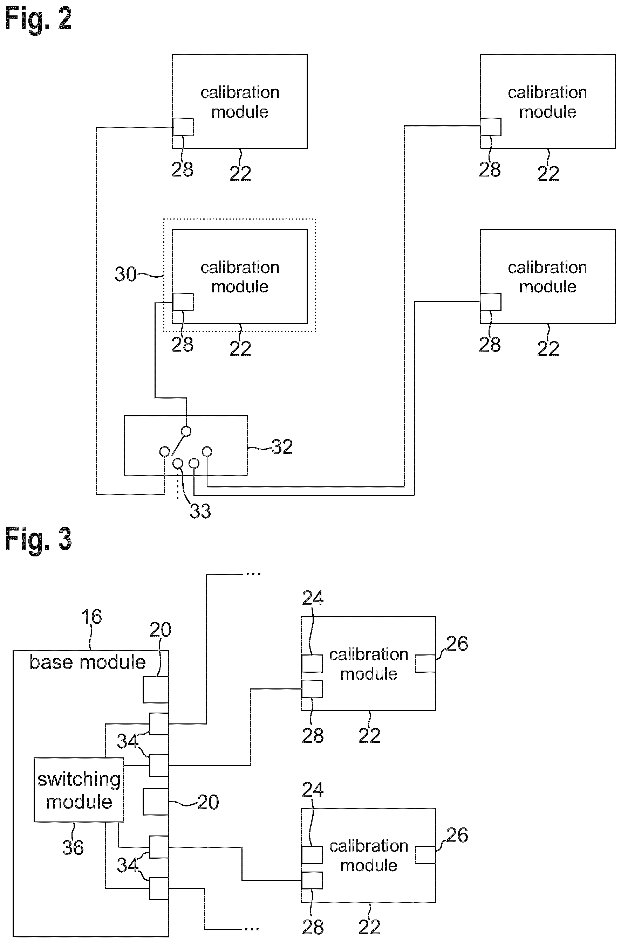

A further variant for connecting the calibration modules 22 with each other is shown in Figure 2, wherein the calibration modules 22 can be connected to the reference module 30 via a switching module 32 consecutively.

Accordingly, a single communication port 28 may be sufficient for each of the calibration modules 22.

In this exemplary embodiment, the calibration modules 22 are arranged in a star topology.

The switching module 32 may comprise at least one extension port 33 that may be connected to at least one further switching module, wherein the at least one further switching module is connected to further calibration modules 22.

Accordingly, the at least one extension port 33 allows to interconnect several groups of calibration modules 22 that are each connected to a respective switching module 32.

It is noted that the base modules 16 and the other ports of the calibration modules 22 are not shown in Figure 2 in order to avoid visual clutter. However, these are, of course, understood to be present nevertheless.

Figure 3 shows a further exemplary variant for the cross-connection between the calibration modules 22.

In this exemplary embodiment, the connections between the communication ports 28 extend partially through one of the base modules 16.

In fact, the base module 16 may comprise a plurality of connection ports 34 and a switching module 36, wherein the switching module 36 is configured to selectively connect the connection ports 34 with each other.

This way, the communication ports 28 of the calibration modules 22 can be selectively connected with each other.

It is emphasized that the variants of the cross-connections between the calibration modules 22 described above are exemplary, and that an arbitrary suitable connection topology, such as a tree topology, and an arbitrary connection type may be used.

For example, the connection ports 34 may be distributed over a plurality of base modules 16, 18, and the base modules 16, 18 may be interconnected via a dedicated port or dedicated ports.

As another example, the communication ports 28 may be identical to the base ports 24, i.e. the RF connections between the RF ports 20 and the base ports 24 may also be used for the cross-connection between the calibration modules 22.

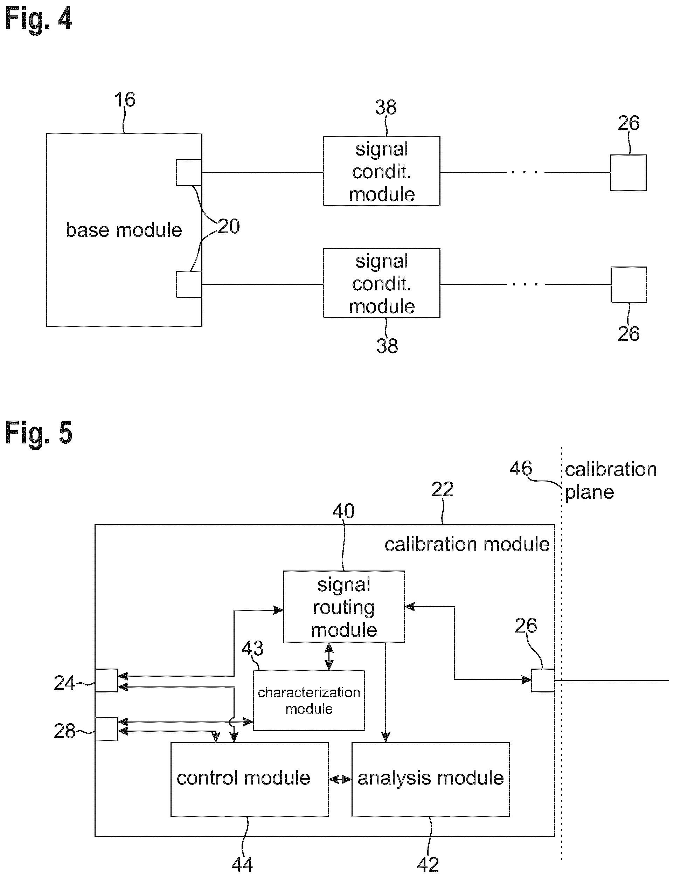

Figure 4 shows a portion of the multi-port calibration system 12 comprising one of the base modules 16.

As is illustrated in Figure 4, a signal-conditioning module 38 may be provided in each signal path between an RF port 20 and the respectively connected test port 26.

The signal-conditioning modules 38 may each comprise an amplifier, an attenuator, a filter, a frequency translator, a delay unit, and/or any other suitable type of signal-conditioning circuitry.

The signal-conditioning modules 38 may be provided separately from the base modules 16 and the calibration modules 22.

Alternatively, the signal-conditioning modules 38 may be integrated into the calibration modules 22.

According to another variant, the signal-conditioning modules 38 may be partially integrated into the calibration modules 22.

It is noted that the exact transmission properties of the signal-conditioning modules 38, such as a frequency response, an amplitude response, and/or a phase response, do not have to be known precisely, as these can be characterized during the calibration described below.

Figure 5 shows one of the calibration modules 22 in more detail.

The test port 26 of the calibration module 22 is internally connected to the base port 24.

In the exemplary embodiment shown in Figure 5, the test port 26 is connected to the base port 24 by a signal routing module 40, such that an RF signal received via the base port 24 is forwarded to the test port 26 by the signal routing module 40.

For example, the signal routing module 40 may be or comprise a directional coupler or other suitable type of circuitry.

The calibration module 22 further comprises an analysis module 42.

The analysis module 42 is connected to the signal routing module 40, such that at least a portion of the RF signal received is forwarded to the analysis module 42.

It is noted that the analysis module 42 may be provided in each calibration module 22, only in selected calibration modules 22, or only in one calibration module 22.

Alternatively, the analysis module 42 may be integrated into one or both of the base modules 16, 18.

As a further alternative, the analysis module 42 may be provided separately from the calibration modules 22 and from the base modules 16, 18. For example, the analysis module 42 may be integrated into a central control device that may be connected to the base modules 16, 18, and to the calibration modules 22.

In the exemplary embodiment shown in Figure 5, the calibration module 22 further comprises a characterization module 43 and a control module 44.

The characterization module 43 is connected to the signal routing module 40, such that the RF signal received is forwarded to the characterization module 43.

The characterization module 43 is also connected to the at least one communication port 28.

The characterization module 43 is optional. Alternatively, the signal routing module 40 may be connected to the at least one communication port 28 directly.

Moreover, it is noted that the characterization module 43 may be provided in each calibration module 22, only in selected calibration modules 22, or only in one calibration module 22.

Alternatively, the characterization module 43 may be integrated into one or both of the base modules 16, 18.

As a further alternative, the characterization module 43 may be provided separately from the calibration modules 22 and from the base modules 16, 18. For example, the characterization module 43 may be integrated into a central control device that may be connected to the base modules 16, 18, and to the calibration modules 22.

The control module 44 is connected to the analysis module 42.

The control module 44 may further be connected to the base port 24 and/or to the at least one communication port 28.

It is noted that a control module 44 may be provided in each calibration module 22, only in selected calibration modules 22, or only in one calibration module 22.

Alternatively, the control module 44 may be integrated into one or both of the base modules 16, 18.

As a further alternative, the control module 44 may be provided separately from the calibration modules 22 and from the base modules 16, 18. For example, the control module 44 may be integrated into a central control device that may be connected to the base modules 16, 18, and to the calibration modules 22.

As will be explained in more detail below, the calibration module 22 has an associated calibration plane 46 that is located at the test port 26.

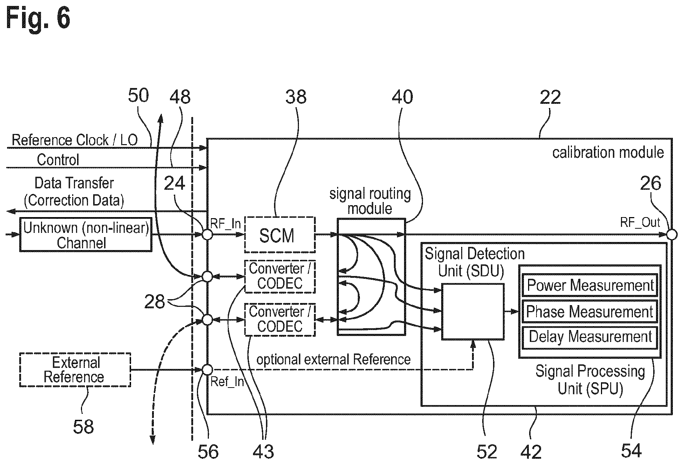

Figure 6 schematically shows a further variant of the calibration module 22, wherein it is to be understood that features may be interchanged between the different variants described.

As already mentioned above, the connection between the RF ports 20 and the base ports 24 may have unknown properties, which is indicated by "unknown (non-linear) channel" in Figure 6.

In the variant shown in Figure 6, the control module 44 may be provided in one of the base modules 16, 18 or as a separate device, and the calibration module 22 may receive a control signal 48 from the control module 44.

Moreover, the calibration module 22 may receive a reference clock and/or a local oscillator signal from the respective base module 16, 18 for frequency synchronization.

The variant shown in Figure 6 may correspond to the daisy chain topology that is also shown in Figure 1.

Accordingly, the signal routing module 40 connects the communication ports 28 with each other. Therein, the calibration module 22 comprises a characterization module 43 for each communication port 28.

For example, the characterization modules 43 may each comprise a converter unit and/or a codec, the functionality of which will be described in more detail below.

The signal routing module 40 also connects the communication ports 28 to the analysis module 42.

In the exemplary variant shown in Figure 6, the analysis module 42 comprises a signal detection unit 52 and a signal processing unit 54.

However, it is to be understood that any other suitable signal processing and/or analysis circuitry may be used.

Optionally, the calibration module 22 may comprise a reference input 56 that can be connected to an external reference signal source 58.

The reference input is connected to the analysis module 42, particularly to the signal detection unit 52, such that an external reference signal provided by the external reference signal source 58 is forwarded to the analysis module 42.

The external reference signal may serve as a reference for the calibration described hereinafter, particularly instead of an RF signal received by the reference module 30.

The multi-port calibration system 12 is configured to calibrate the test and/or measurement system 10 as described hereinafter.

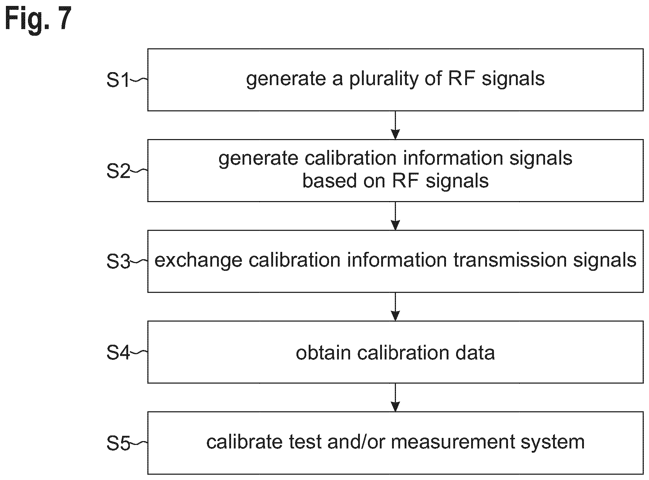

More precisely, the multi-port calibration system 12 is configure to perform a calibration method of calibrating the test and/or measurement system 10, which is described hereinafter with reference to Figure 7.

A plurality of RF signals is generated by the base modules 16, wherein the plurality of RF signals is output by the RF ports 20 and forwarded to the base ports 24 (step S1).

More precisely, the RF signals may be generated by the signal sources 21.

The plurality of RF signals may be equal to each other.

However, it is also conceivable that different RF signals being intended for different ports of the device under test 14 are generated.

Each calibration module 22 receives the respective RF signal and generates a corresponding calibration information signal based on the RF signal received (step S2).

In the exemplary embodiments of the calibration modules 22 shown in Figures 5 and 6, the RF signal is forwarded to the characterization module(s) 43 by the signal routing module 40.

The characterization module 43 processes or rather analyzes the RF signal, thereby obtaining characteristic signal parameters of the respective RF signal, wherein the calibration information signal comprises the characteristic signal parameters.

For example, the characteristic signal parameters may comprise an amplitude of the RF signal, a signal level of the RF signal, a phase of the RF signal, a delay of the RF signal, and/or a signal to noise ratio of the RF signal.

The calibration information signal may be an analog signal or a digital signal.

It is noted that, alternatively, the RF signals may be forwarded to the communication ports 28. In this case, the calibration information transmission signals are equal to the RF signals received.

The calibration information signals are exchanged between the calibration modules 22 via the communication ports 28 (step S3).

For example, each calibration module 22 may transmit its calibration information signal to each other calibration module 22.

Accordingly, each calibration module 22 receives a calibration information signal from each other calibration module 22.

As another example, each calibration module 22 that is not the reference module 30 transmits the calibration information signal to the reference module 30.

In other words, the reference module 30 receives a calibration information signal from each of the other calibration modules 22.

The reference module 30 transmits its calibration information signal to each of the other calibration modules 22.

In other words, each of the other calibration modules 22 receives a calibration information signal from the reference module 30.

During the calibration, the reference module 30 may always be the same calibration module 22.

Alternatively, different calibration modules 22 may be designated as reference module 30 consecutively.

In this case, a global reference may be determined that serves as reference for the calibration of the different reference modules 30 among each other.

Alternatively, the different reference modules 30 may transmit the respective calibration information signal to each of the other reference modules 30.

Each calibration module 22 compares the calibration information signals received from the other calibration modules 22 with the respective RF signal received, thereby obtaining calibration data (step S4).

More precisely, the analysis module 42 processes the calibration information signals received and the RF signal received, thereby obtaining the calibration data.

The calibration data may comprise information on amplitudes, power levels, phases, and/or delays of the individual RF signals.

Therein, the analysis module 42 may process all of the calibration information signals and the RF signal simultaneously.

Alternatively, the analysis module 42 may process the calibration information signals and/or the RF signal consecutively.

The calibration data obtained by the calibration modules 22 may be forwarded to the control module(s) 44.

Based on the calibration data obtained by the different calibration modules 22, the test and/or measurement system is calibrated (step S5).

In fact, the base modules 16, 18 and/or the signal-conditioning modules 38 may be controlled, particularly by the control module(s) 44, to adapt the signal parameters of the RF signals based on the calibration data.

More precisely, the signal parameters of the RF signals may be adapted such that a respective test signal that corresponds to the RF signal and that is output via the respective test port 26 meets requirements of a measurement to be performed on the device under test 14.

Accordingly, by means of the calibration, the signal characteristics of the test signals at the predefined calibration planes 46 can be set.

For example, the amplitude, phase, and/or delay of each RF signal and thus of each test signal may be adapted individually based on the calibration data.

In other words, the different calibration modules 22 are equilibrated such that the properties of the test signals at the different calibration planes have predefined properties relative to each other, e.g. relative amplitudes, relative phases and/or relative delays of the test signals.

If necessary, the calibration data may be forwarded to other calibration modules 22 and/or to the base modules 16, 18, particularly to the control module(s) 44 controlling the base modules 16, 18, and/or the signal-conditioning modules 38.

It is noted that prior to the calibration described above, a single-port calibration of at least the reference module 30 may be performed in order to correct the transmission path between the corresponding base module 16, 18 and the test port 26 of the reference module 30.

If no reference module 30 is designated, the single-port calibration may be performed for each of the calibration modules 22.

It is emphasized that during the calibration method described above, the device under test 14 does not have to be connected to the test ports 26. In other words, the device under test 14 may be detached from the calibration modules 22 during the calibration.

After the calibration is performed, the device under test 14 may be connected to the calibration modules 22, or more precisely to the test ports 26 of the calibration modules 22.

Alternatively, the calibration modules 22 may disconnect the test port 26 from the base port 24 during the calibration, e.g. by a suitable switch. In this case, the device under test 14 can remain connected to the test ports 26 during the calibration.

With the calibration method described above, the test and/or measurement system 10 is calibrated up to the predetermined calibration planes 46, which are located at the test ports 26 of the calibration modules 22.

If further components with known characteristics are provided between the test ports and the device under test 14, the calibration planes 46 can optionally be relocated downstream of these components by any suitable de-embedding technique.

After calibration of the test and/or measurement system, different types of measurements may be performed depending on the device under test 14, wherein test signals can be applied to the device under test 14 via the different test ports 26.

The device under test 14 may process the test signals and corresponding processing results obtained by the device under test 14 may be analyzed in order to assess a performance of the device under test 14.

If the device under test 14 is configured to generate output signals based on the test signal(s) received, these output signals may be analyzed in order to assess the performance of the device under test 14.

For this purpose, the calibration modules 22 may have an integrated backward channel for transmitting measurement signals from the device under test 14 to the analysis module(s) 42, the base module(s) 16, 18, and/or to a separate measurement device.

In fact, the backward channel may be established by the same connection used for transmitting the RF signal from the respective base module 16, 18 to the device under test 14.

The measurement signals received by the test ports 26 from the device under test 14, i.e. test signals processed by the device under test 14 and/or test signals reflected at the device under test 14, may be analyzed by the analysis modules 42, by the base modules 16, 18, and/or by a separate measurement device.

Therein, undesired reflections of the test signals at the ports of the device under test 14 may be accounted and corrected for in real time by the analysis module(s) 42.

The calibration modules 22 may comprise at least one backward channel for transmitting the corresponding measurement signal to the base modules 16, 18.

Alternatively, a separate connection may be provided for the backward channel.

It is noted that, if the calibration modules 22 do not comprise a backward channel, and a device under test 14 transmitting output signals is to be measured, it is also conceivable to connect the base ports 24 of the calibration modules to the ports of the device under test 14.

Optionally, the test ports 24 may be connected to the base modules(s) 16, 18 if they have integrated analysis capabilities, or to a separate measurement device.

In this case, steps S1 to S4 described above may be performed analogously, but with the device under test 14 generating the RF signals (namely the output signals of the device under test 14), and the obtained "calibration data" being equal to measurement results with respect to the output signals generated by the device under test 14.

In fact, in the configuration with the device under test 14 being connected to the base ports 24, the device under test 14 may be calibrated by performing steps S1 to S5 described above, but for the device under test 14 generating the RF signals.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A calibration module for a multi-port calibration system (12),
wherein the calibration module (22) comprises at least one base port (24), wherein the at least one base port (24) is connectable to a base module (16, 18), and wherein the at least one base port (24) is configured to receive a radio frequency, RF, signal,
wherein the calibration module (22) comprises at least one test port (26), wherein the at least one test port (26) is connectable to a device under test (14), wherein the calibration module (22) is configured to output, via the at least one test port (26), a test signal corresponding to the RF signal,
wherein the calibration module (22) comprises at least one communication port (28), wherein the at least one communication port (28) is connectable to at least one further calibration module (22),
wherein the calibration module (22) is configured to transmit a calibration information signal to the at least one further calibration module (22) via the at least one communication port (28), wherein the calibration information signal comprises information on the RF signal received, and
wherein the calibration module (22) is configured to receive at least one further calibration information signal from the at least one further calibration module (22) via the at least one communication port (28), wherein the at least one further calibration information signal comprises information on at least one further RF signal received by the at least one further calibration module (22).

2. The calibration module of claim 1, wherein the calibration information signals comprise characteristic signal parameters of the respective RF signal, particularly wherein the characteristic signal parameters comprise an amplitude of the RF signal, a signal level of the RF signal, a phase of the RF signal, a delay of the RF signal, and/or a signal to noise ratio of the RF signal.

3. The calibration module according to claim 2, wherein the calibration module (22) comprises a characterization module, wherein the characterization module is configured to process the RF signal received, thereby obtaining the characteristic signal parameters.

4. The calibration module according to any one of the preceding claims, wherein the calibration module (22) comprises an analysis module (42), wherein the analysis module (42) is configured to obtain calibration data based on the RF signal received and based on the at least one further calibration information signal.

5. The calibration module according to any one of the preceding claims, wherein the calibration module (22) comprises at least one backward channel, wherein the calibration module (22) is configured to transmit the calibration information signal and/or a measurement signal to the base module (16, 18) and/or to a central control device via the backward channel.

6. A multi-port calibration system, wherein the multi-port calibration system (12) comprises at least one base module (16, 18) and at least two calibration modules (22), wherein the at least two calibration modules (22) are each configured according to any one of the preceding claims,
wherein the at least one base module (16, 18) comprises at least two RF ports (20), wherein the at least two RF ports (20) are connected to the base ports (24) of the at least two calibration modules (22), and
wherein the communication ports (28) of the at least two calibration modules (22) are connected with each other.

7. The multi-port calibration system of claim 6, wherein the multi-port calibration system (12), particularly the at least one base module (16, 18) and/or at least one of the at least two calibration modules (22), comprises a control module (44), wherein the control module (44) is configured to generate a control signal for adapting the RF signal and/or the at least one further RF signal.

8. The multi-port calibration system of claim 6 or 7, wherein the multi-port calibration system (12) comprises at least one signal-conditioning module (38) for each signal path between the RF ports (20) and the test ports (26).

9. The multi-port calibration system of claim 8, wherein the at least one signal-conditioning module (38) comprises an amplifier, an attenuator, a filter, a delay unit, and/or a frequency translator.

10. The multi-port calibration system according to any one of claims 6 to 9, wherein the at least one base module (16, 18) is a signal generator, a vector network analyzer, an oscilloscope, or a spectrum analyzer.

11. The multi-port calibration system according to any one of claims 6 to 10, wherein the at least two calibration modules (22) are connected with each other via a daisy chain and/or via a connection having a star topology.

12. The multi-port calibration system according to any one of claims 6 to 11, wherein the at least two calibration modules (22) are connected to each other directly or via the at least one base module (16, 18).

13. The multi-port calibration system according to any one of claims 6 to 11, wherein one of the at least two calibration modules (22) serves as reference module (30) for calibration of the multi-port calibration system (12).

14. The multi-port calibration system according to any one of the preceding claims, wherein each of the at least two calibration modules (22) comprises a housing, or wherein the at least two calibration modules (22) are arranged in a common housing.

15. A calibration method of calibrating a test and/or measurement system (10), wherein the calibration method comprises the steps of
- generating, by at least one base module (16, 18), a plurality of RF signals;
- forwarding the plurality of RF signals to a plurality of calibration modules (22), wherein the calibration modules (22) are configured according to any one of claims 1 to 5;
- exchanging calibration information signals between the calibration modules (22), wherein the calibration information transmission signals comprise information on the RF signals;
- obtaining calibration data based on the calibration information signals; and
- calibrating the test and/or measurement system (10) based on the calibration data.
